# EUROPEAN PATENT SPECIFICATION

(11) **EP 2 239 589 B1**
(45) Date of publication and mention of the grant of the patent: **09.05.2012**
(21) Application number: 10159361.4
(22) Date of filing: 08.04.2010
(51) Int. Cl.: G01R 31/02

(54) **Device, method and assembly for integrity checking of electrical wiring**
Vorrichtung, Verfahren und Anordnung zur Integritätsprüfung elektrischer Verkabelung
Dispositif, procédé et assemblage pour vérifier l'intégrité d'un câblage électrique

(30) Priority: 09.04.2009 NL 2002741
(43) Date of publication of application: 13.10.2010
(73) Proprietor: Ascom (Sweden) AB, 402 73 Göteborg (SE)
(72) Inventor: Luik, Dhr: Harold, 2402 HS, Alphen aan den Rijn (NL)
(74) Representative: Van Someren, Petronella F. H. M.

(56) References cited:
- EP-A2- 0 759 558
- GB-A- 2 094 487
- GB-A- 2 155 223
- US-A- 4 649 821
- US-A- 5 045 840

## Description

The present invention is related to an assembly for determining the integrity of electrical wiring, said electrical wiring being connected to a normally open device at one end thereof. It further relates to a device for measuring an electrical state of a normally off device connected thereto by electrical wiring which comprises such an assembly. In addition, the present invention relates to a method for determining the integrity of electrical wiring having connected a normally open device at one end thereof.

Normally open devices present the problem that due to their high impedance it is difficult to determine whether the electrical wiring used to connect them is failing or not.

An important example is a push button used in hospitals to call a nurse. Such buttons are connected to or form part of a peripheral that belongs to a nurse call system. The peripheral is a (wall) mounted unit which is connected to a central room controller. Normally, each patient or bed is assigned to a peripheral. The push button is connected to this wall unit using electrical wiring. Typically, the push button is part of a small unit which a patient can for instance place close to his or her bed. In case of required medical assistance, the patient can call a nurse by pressing the push button. In addition, other buttons can be included in the same unit.

A push button is a normally off device, i.e. most of the time it is in a high impedance state. Hence, at the side of the wall mounted unit, it is difficult to detect failing wiring. For instance, the electrical behaviour of an open connection in the electrical wiring resembles the behaviour of the normally open device in the high impedance state.

Therefore, a need arises to check the integrity of the electrical wiring. Should the wiring fail, a signal can then be sent to the operator to correct this deficiency. Additionally or alternatively, a nurse can be called to check the condition of the patient.

Additional examples of normally open devices are fire or smoke sensors, switches or contacts of medical devices like ventilator and infusion-pump alarm contacts. US Patent US 4649821 A discloses an electrical circuit test apparatus for determining the integrity of electrical wiring in the context of a firing unit, said electrical wiring being connected to a normally open device at one end thereof, wherein the assembly comprises a capacitor which is connected in parallel to said normally open device; and an integrity measuring device which is connected to another end of said electrical wiring. The integrity measuring device comprises supply means for applying electrical supply to said another end of said electrical wiring, measuring means for measuring at least one electrical parameter and determining means for determining the integrity of said electrical wiring using said at least one electrical parameter and for outputting a signal indicative of said integrity.
UK patent application GB 2094487 A likewise discloses an ignition circuit monitor for checking of wire integrity. Similar problems occur in terms of differentiating between normal operation and failing electrical wiring.

The present invention provides an assembly to meet this need. This assembly comprises a capacitor which in an assembled state of the assembly is connected in parallel to the normally open device. The latter is connected to one end of the electrical wiring. Furthermore, it comprises an integrity measuring device, which in the assembled state is connected to another end of the electrical wiring. The integrity measuring device comprises supply means for applying electrical supply to said another end of the electrical wiring, discharging means for discharging the capacitor from said another end of the electrical wiring, measuring means for measuring at least one electrical parameter at said another end, and switching means for switching at least one of the supply means and the discharging means to said another end of the electrical wiring. These switching means are arranged to switch the integrity measuring device between a charging state, in which the supply means charge the capacitor, and a discharging state, in which the discharging means discharge the capacitor. In addition, the integrity measuring device comprises determining means for determining the integrity of the electrical wiring using said at least one electrical parameter and for outputting a signal indicative of the integrity.

The assembly according to the invention is characterized in that the determining means are arranged to determine the integrity in dependence of a transient response to a switch from the discharging state to the charging state.

The behaviour after a switch from the discharging state to the charging state, and especially if the capacitor is completely or almost completely discharged, is that of a capacitive element. As such, a relatively large current will flow through the electrical wiring to charge the capacitor. The discharging means are therefore preferably arranged to substantially fully discharge the capacitor. In case of failing electrical wiring, the current flow is interrupted or severely impeded and charging will not occur or at least at a much slower pace.

The transient response preferably corresponds to a response of a capacitive element to a voltage or current step. This step arises because of the switching of the supply means by the switching means. Examples of supply means are a voltage and or a current source.

Because most of the current flows during the initial phase after switching, it is advantageous if the determining means are arranged to determine the integrity during the charging state before substantial voltage build-up has occurred in the capacitor.

The determining means could for instance comprise comparing means for comparing said at least one electrical parameter to at least one predetermined limit. For example, a measured current could be compared to a current threshold value which can be expected to occur during the initial charging of the capacitive element, which is connected to the electrical wiring in question. Such a threshold can be determined or influenced by the parameters of the electrical wiring itself, e.g. the self resistance or conductance.

Preferably, the at least one electrical parameter comprises at least one of a current through the electrical wiring and a voltage at said another end of the electrical wiring. This voltage preferably corresponds to or is related to the voltage difference over the capacitor. This parameter is convenient because after the discharging step the voltage over this capacitor should be small. In case of failing electrical wiring this voltage, when measured at said another end, is high. When the electrical wiring is connected between a voltage source and ground, the measured voltage in this case would correspond to the voltage outputted by the voltage source. It should be noted at this point, that it should be obvious to the skilled person that other voltages or currents may be determined that are derived from the abovementioned voltage or current.

Preferred examples of discharging means are one or a combination of a voltage source, a current source and means for shorting the electrical wiring at said another end. To illustrate the latter, a switch could be present between the relevant terminals of the electrical wiring.

Typically, electrical wiring comprises more than one core. These cores can be coupled together to form a cable or separate wires may run back and forth between the supply means and the normally off device. In general, a first and second terminal of the electrical wiring can be identified. These terminals are in electrical contact with the normally off device and the capacitor. It is further assumed that the first terminal is connected to the supply means at least in the charging state. In the discharging state the supply means may, depending on the topology used, be disconnected from the first terminal.

The measuring means could for instance comprise a current meter connected to at least one of the first and second terminal, wherein the integrity signal is indicative of failing electrical wiring if the measured current is below a predetermined limit. A low current would indicate an impedance barrier in the electrical wiring indicative of electrical failure.

The measuring means could alternatively or additionally comprise a resistor connected in between the supply means and the first terminal and a voltage meter to measure a voltage drop over the resistor in the charging state. In this case, the integrity signal is indicative of failing electrical wiring if the voltage drop is below a predetermined limit. A low voltage drop would implicate that the capacitor has not been discharged or, that due to an impedance barrier such as an open, most of the applied voltage falls over the electrical.

Additionally or alternatively, the measuring means could comprise a voltage meter to measure a wire voltage over said electrical wiring in said charging state. Then, the integrity signal is indicative of failing electrical wiring if the wire voltage is above a predetermined limit.

Additionally or alternatively, the measuring means comprise a resistor connected to the second terminal and a voltage meter to measure a voltage over the resistor, wherein the integrity signal is indicative of failing electrical wiring if the voltage is below a predetermined limit. As discussed above, when the electrical wiring fails most or all of the applied voltage falls over the electrical wiring.

Preferably, the discharging means comprise a voltage source and or a current source connectable to the second terminal. For instance, if a voltage source is connected to the first terminal as supply means, the capacitor can be discharged by connecting a voltage source of equal voltage magnitude to the second terminal. The switching means could in this case, or in general, comprise a controllable switch in between the aforementioned voltage source and or current source for discharging the capacitor and the second terminal.

Additionally or alternatively, the discharging means could comprise shorting means, such as a controllable switch, for shorting the electrical wiring between the first and second terminal. Then, the capacitor would discharge through these shorting means. In this case, or in general, the switching means could comprise a controllable switch in between the supply means and the first terminal.

Additionally or alternatively, the discharging means comprise a voltage source and or a current source connectable to the first terminal. In this case, or in general, the switching means could comprise a controllable switch in between the voltage and or current source and the first second terminal.

In a preferred embodiment the assembly comprises a micro-controller having at least one input port for measuring said at least one electrical parameter at said another end, and at least one output port connected to said second terminal, wherein said micro-controller is programmed or arranged to periodically output a high voltage level for discharging said capacitor. This high voltage level preferably corresponds to a supply voltage applied to the electrical wiring by the supply means and or the micro-controller.

It is advantageous if the output port of the micro-controller is a tri-state port. Such a port can attain a high impedance state when it is not used for discharging the capacitor. As such, it does not present a load to the system.

In a particular advantageous embodiment, the input and output port are combined into one I/O port connected to the second terminal. In this case, or in general, the micro-controller is arranged to periodically switch the behaviour of the I/O port between that of said input port and that of said output port. For instance, the I/O port periodically outputs a voltage pulse sufficient to discharge the capacitor. After this relatively short pulse, the I/O port re-assumes its input port state.

An advantageous solution is to connect the I/O port to the second terminal and to a resistor connected to ground. The voltage drop over this resistor is measured after a switch from the discharging state to the charging state. When the voltage over this resistor remains low, most of the voltage applied by the supply means drops over the electrical wiring, which is an indication that the wiring is failing.

The advantage of using a micro-controller is that most of the components mentioned above, e.g. the determining means and or the switching means, can be implemented or integrated in the micro-controller.

As mentioned before, an example of a normally off device is a switch. It should be noted that having the capacitor parallel to the switch also improves the debouncing of the switch and the resulting EMC performance.

The present invention also provides a device for measuring an electrical state of a normally off device connected thereto by electrical wiring. It comprises an assembly for determining the integrity of the electrical wiring as previously discussed in an assembled state. The state measuring device further comprises second measuring means for measuring at least one second electrical parameter and second determining means for determining the state of said normally off device based on said at least one measured second electrical parameter.

The state measuring device, and more in particular the second measuring means and or the second determining means, could be arranged to only or also determine the state during the charging state after substantial charge build-up in the capacitor. When the normally off device changes state, for instance when a switch is pressed, the electrical response due to this action could resemble the transient behaviour of the discharged capacitor. In fact, the capacitor will discharge through the closed switch. Therefore, it is difficult to determine whether the switch has been pressed or if the measured at least one second electrical parameter corresponds to the normal behaviour of a discharged capacitor during the initial charging. Measuring after substantial charge build-up in the capacitor during the charging state prevents this problem. For instance, if the micro-controller is used with binary input ports, the measurement preferably takes place after the voltage over the capacitor has reached such a value that the measured value by the micro-controller changes from a "0" to a "1", or vice versa, depending on the topology used. To elaborate a bit further, if the micro-controller is used to measure a voltage drop over a resistor connected to the second terminal as discussed before, a relatively large voltage over the capacitor will cause a relatively low voltage over the resistor. The micro-controller will consequently measure a "0" instead of a "1" after a switch from the discharging state to the charging state and after sufficient voltage has developed over the capacitor. Changing the state of the normally off device will result in a large current flow through the resistor causing a "1" to be detected by the micro-controller.

However, the problem mentioned above can be obviated if the measuring means are arranged to measure said at least one second electrical parameter at least twice during initial charging of said capacitor. In this case, or in general, the second determining means are arranged to determine the state of said normally off device using said at least two measurements of said at least one electrical parameter. By means of example, the initial charging of the capacitor will follow an exponential curve. If during the initial charging, the state of the normally off device changes, the capacitor could discharge through this device causing a step in the charging behaviour. By measuring two or more values, it can be determined whether the behaviour follows the expected exponential behaviour or if a state change has occurred.

It should be noted that the measuring means and the second measuring means and or the determining means and the second determining means can be integral components. Different predetermined limits may in this case be used to differentiate between the different functionalities. For instance, the measuring means may first determine the integrity using a first limit. Subsequently, the same measuring means may be used to determine a state change using a different limit. Of course, it is also possible that both or all limits are the same, and even, that the different measurements are performed simultaneously, i.e. the same parameter(s) is/are used to determine a possible state change and the integrity of the electrical wiring simultaneously.

An example of such a state measuring device could be a peripheral suitable for connecting to a nurse call system as previously discussed. As mentioned, in this case the normally off device could be a push button operable by a patient for calling medical assistance.

The present invention also provides a method for determining the integrity of electrical wiring having connected a normally open device at one end thereof. This method comprises connecting a capacitor in parallel to said normally open device, applying an electrical supply to another end of said electrical wiring, disconnecting said electrical supply from said another end, measuring at least one electrical parameter at said another end, and determining said integrity using said at least one electrical parameter and outputting a signal indicative of said integrity. The method according to the present invention is characterized in that prior to said measuring at least one electrical parameter at said another end the capacitor is discharged from said another end after which an electrical supply is applied to said another end for charging the capacitor. It is characterized further in that said integrity is determined in dependence of a transient response to said switch from said discharging to said charging.

The present invention will now be described using embodiments thereof that are illustrated in the attached drawings, wherein:
Figure 1 shows a nurse call system in which the present invention can be used to improve reliability;
Figure 2 presents a schematic overview of the assembly according to the invention;
Figures 3, 4, and 5 illustrate various possible circuit topologies which can be used to implement the invention;
Figures 6 and 7 show circuit topologies in which a micro-controller is used for discharging the capacitor and for measuring an electrical parameter.

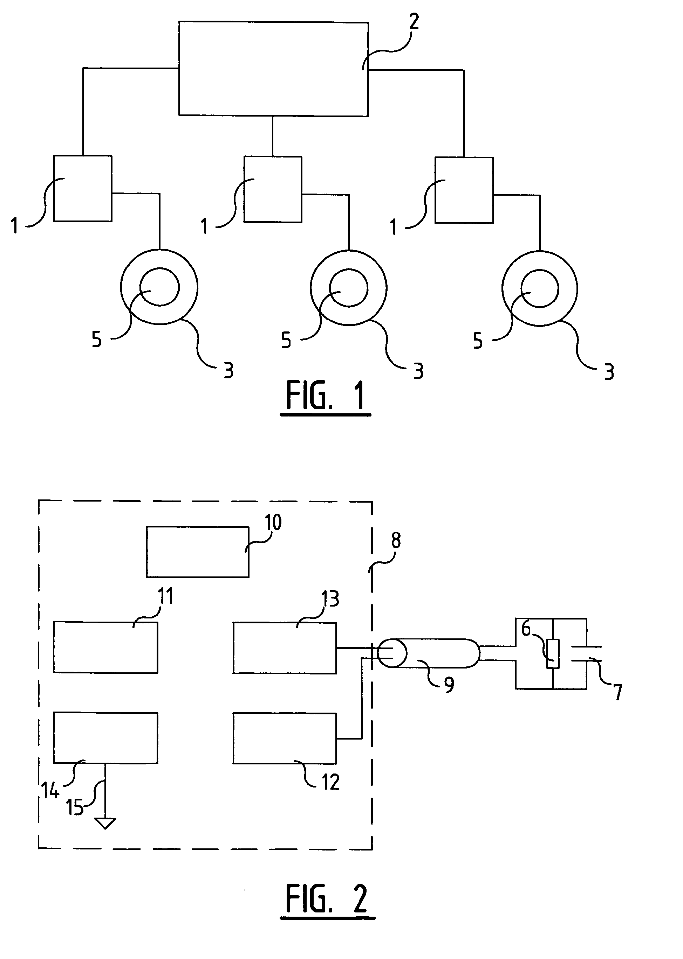

Figure 1 shows a further circuit topology in which a micro-controller is used wherein input and output ports are combined.

Figure 1 demonstrates a nurse call system in which the present invention can be used to improve reliability. The nurse call system comprises a plurality of peripherals 1 that are connected to a room controller 2. Peripherals 1 are mostly mounted on a wall near a patient's bed. To be able to operate peripheral 1 while lying in bed, the patient can use a remote controller 3 that has a wired connection 4 to peripheral 1. Remote controller 3 for instance comprises a push button switch 5 to call for medical assistance. Because this switch presents a high impedance when not operated, it is difficult to differentiate between a normal situation with the switch not being operated and a situation in which the electrical wiring fails. In case of an open connection, pressing push button switch 5 will not result in a nurse being called, and a patient health would be at risk.

Figure 2 shows a schematic overview of the assembly according to the invention. In this figure a device under test 6 (DUT) being a normally off device, is connected in parallel to a capacitor 7. This parallel combination is connected to an integrity measuring device 8 via electrical wiring 9. Integrity measuring device 8 comprises supply means 10 for applying electrical supply to the electrical wiring, discharging means 11 for discharging the capacitor, measuring means 12 for measuring an electrical parameter, switching means 13 for switching at least one of the supply means and the discharging means to the electrical wiring, and determining means 14 for determining the integrity of the electrical wiring using the measured electrical parameter(s) and for outputting a signal 15 indicative of the integrity.

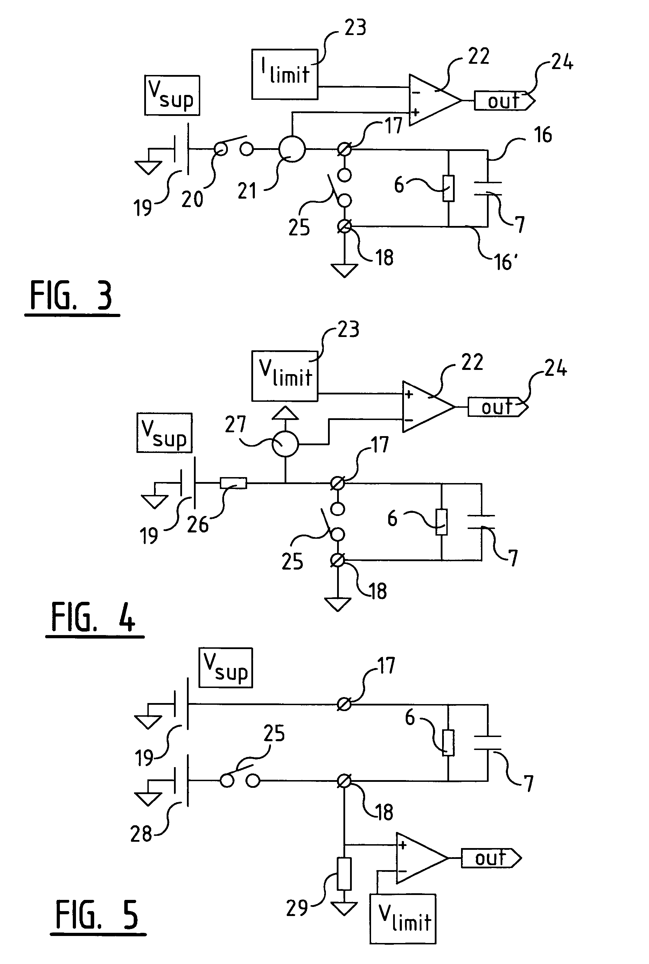

Figure 3 shows a possible configuration to implement the assembly according to the invention. In this case the electrical wiring is represented by a two core cable comprising cores 16 and 16'. At the end opposing DUT 6, two terminals are present, first terminal 17 and second terminal 18. Second terminal 18 is connected to ground, whereas first terminal 17 is connected to a voltage supply 19 via a switch 20 and a current meter 21. Current meter 21 relays the measured current to a comparator 22, which compares the measurement with a predetermined limit 23. The result of this comparison is outputted as an integrity signal at the output 24 of comparator 22. Between first terminal 17 and second terminal 18 a second switch 25 is connected that will be used to short the electrical wiring to thereby discharge capacitor 7 as will be described next.

Under normal circumstances, i.e. the electrical wiring is not failing and therefore has a high integrity, capacitor 7 will charge up to Vsup, assuming that switch 20 is closed and switch 25 is open. If in this case switch 20 is opened and switch 25 is closed, the capacitor will discharge through switch 25. In this situation current meter 21 will not measure any significant current flow. Once substantially or fully discharged, switch 20 is closed and switch 25 is opened. Both switches are operated by a controller (not shown) which is part of the switching means. Then, the capacitor will once again start to charge. Due to the high step response, i.e. a voltage step equal to Vsup if the capacitor has been fully discharged, a large current will flow through current meter 21 towards capacitor 7. Comparator 22 will compare this current with a predetermined limit Ilimit 23. Because during the charging of capacitor 7 the current will vary exponentially, it is advantageous if the measurement of the current and or the comparison with predetermined limit 23 is synchronized with the switching of switches 20 and 25. To this end, the controller controlling switches 20 and 25 could also be arranged to control comparator 22 and or current meter 21. For example, comparator 22 could be arranged to make the comparison a few microseconds after switch 20 has closed. It should be obvious to the skilled person that a relationship exists between the predetermined limit that is to be used, the timing of the measurement and or comparison and the characteristics, e.g. self resistance, of the electrical wiring.

In case of failing electrical wiring, the capacitor might not discharge due to an electrical interruption. Consequently, it may also not charge during the charging state. A very low or zero current value will be measured. Hence, in this case and depending on the connection to comparator 22, if comparator 22 determines that the measured current is below predetermined limit 23 a low voltage will be outputted which is indicative of failing electrical wiring. Should the wiring not fail, the opposite holds.

Figures 4 and 5 show alternative embodiments to implement this principle. It should be obvious to the skilled person that other topologies may be used that also employ this principle and therefore also fall within the ambit of the present invention.

In figure 4 the current is sensed using a resistor 26 which is placed in between first terminal 17 and voltage supply 19. If the electrical wiring is not failing, most of the supply voltage will drop over resistor 26. Hence, in this case a low measured value by voltage meter 27 will correspond to reliable wiring. Although shown as a separate component, the voltage meter as such may be omitted if comparator 22 has a high impedance voltage input. In that case, the voltage meter is assumed to be integrated the comparator.

In figure 5, a voltage source 28 is used for discharging capacitor 7. Preferably, this source outputs a voltage comparable or equal to the supply voltage Vsup provided by voltage supply 19. Switch 25 is used to either connect or disconnect voltage source 28. A resistor 29 is connected in between second terminal 18 and ground. If the electrical wiring fails, most of the applied voltage by voltage supply 19 will drop over the electrical wiring. Hence, a low measured voltage is indicative of failing wiring. It should be obvious to the skilled person that the general principle of the present invention should not be construed narrowly such that measuring voltages away from the second or first terminal, but nevertheless related, also falls within the ambit of the present invention.

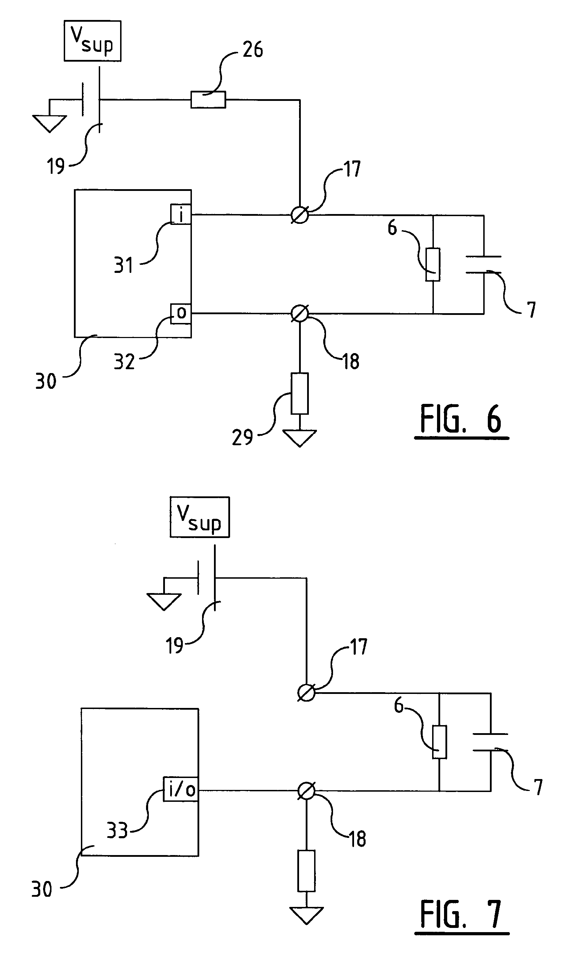

Figure 6 illustrates how a micro-controller 31 can be used in which some of the functionality previously discussed is implemented. The micro-controller in figure 6 is provided with an input port (i) 31 and an output port (o) 32. Input port 31 serves the same purpose as current meter 21 in figure 3. Output port 32 has a function similar to voltage source 28 in figure 5. After a switch from the charging state to the discharging state, a high output voltage, preferably equal to Vsup, is outputted at output port 32. This will discharge capacitor 7. A resistor (not shown) can be placed in between second terminal 18 and micro-controller 30 to limit the current. After full or sufficient discharging, output port 32 is disabled by putting it in a high impedance state (tri-state port). Then, the normal charging process will occur wherein input port 31 will process the measured current or voltage. As such, micro-controller 30 is provided with the switching means, the determining means, and the discharging means.

Normally, micro-controller 30 is also used for other functionality, like measuring the state of normally off device 6. It is therefore very convenient if the integrity measuring functionality can be implemented in the same component. For instance, input port 31 could also be used to determine a state of normally off device 6. In case normally off device 6 is a push button switch, or a device that switches between a high impedance state to a low impedance state, a change in state will cause a significant change in current. This change can be detected by micro-controller 30.

It should be noted that in general the predetermined limits to ascertain whether a state change has occurred or whether the electrical wiring is failing or not can be different. Moreover, micro-controller 30 or the measuring and determining means in general can be adapted to perform measurements regarding the integrity of the electrical wiring at different times than the measurements needed for detection of a state change. For example, the state change detection could occur after substantial charge build-up in the capacitor. A significant amount of current would in this case indicate that the push button has been activated. However, it is also possible to make useful measurements regarding a state change in the early stages after the switch between the discharging state and the charging state. In that case, multiple measurements are taken and compared to the electrical behaviour of a charging capacitor. Any abnormalities, such as a step in the otherwise exponential behaviour, could indicate that a state change has occurred.

Figure 7 shows a particular advantageous embodiment in which micro-controller 30 is provided with an input/output (I/O) port 33 which can act either like an input port or an output port. This port is connected to second terminal 18.

Micro-controller 30 can be arranged to periodically switch the behaviour of I/O port 33 from input port to output port. Once in the latter state, it will output a voltage pulse, preferably having a magnitude of Vsup and of sufficient length to discharge capacitor 7. After this pulse, I/O port 33 will return to its input port state, where it can measure the voltage at the second terminal similarly to the operation discussed under reference to figure 5.

Just as described above, the same port can be used to detect a state change of normally off device 6. In fact, the circuit topology in figure 7 requires no additional components compared to a topology in which the integrity is not checked. The additional required components are all integrated or implemented in micro-controller 30. What is needed to implement the integrity checking functionality is a different programming or arrangement of micro-controller 30. Consequently, the present invention provides a possibility to improve the reliability of such systems without (much) additional resources or costs.

In the description above, the present invention has been described using embodiments thereof. It should be obvious to the skilled person that various modifications are possible without deviating from the scope of the invention which is defined by the appending claims.

It should be noted that the description above has focussed on electrical wiring that may fail by having interrupted connections, i.e. that presents a high impedance. The opposite may also occur. A short circuit may exist in the electrical wiring. However, this situation is less threatening as it resembles the situation in which for instance a push button is switched. In case of a nurse call system a call will be dispatched to a nurse should such a short in the electrical wiring occur. Nevertheless, the general principle of the present invention can also be used for detecting these kinds of failures because also in this case the transient response would be different. The capacitor will not charge because it is shorted. Currents that flow will not show the expected exponential behaviour. These deviations from what is to be expected after a switch from the discharging state to the charging state can be used to determine whether the electrical wiring is failing or not.

Furthermore, in the various embodiments shown in the figures, several possibilities were demonstrated to implement the discharging means, the switching means, the determining means and the measuring means. It should be obvious to the skilled person that other combinations may be made not shown in the figures that do not deviate from the scope of the invention as defined by the claims.

## Claims

1. Assembly for determining the integrity of electrical wiring (9), said electrical wiring being connected to a normally open device (6) at one end thereof, wherein the assembly comprises:
a capacitor (7) which in an assembled state is connected in parallel to said normally open device; and
an integrity measuring device (8), which in an assembled state is connected to another end of said electrical wiring, said integrity measuring device comprising:
supply means (10) for applying electrical supply to said another end of said electrical wiring;
discharging means (11) for discharging said capacitor from said another end of said electrical wiring;
measuring means (12) for measuring at least one electrical parameter at said another end;
switching means (13) for switching at least one of said supply means and said discharging means to said another end of said electrical wiring, wherein said switching means are arranged to switch said integrity measuring device between a charging state, in which said supply means charge said capacitor, and a discharging state, in which said discharging means discharge said capacitor;
determining means (14) for determining the integrity of said electrical wiring using said at least one electrical parameter and for outputting a signal (15) indicative of said integrity;
**characterized in that** said determining means are arranged to determine said integrity in dependence of a transient response corresponding to said at least one electrical parameter to a switch from said discharging state to said charging state.

2. Assembly according to claim 1, wherein:
said discharging means are arranged to substantially fully discharge said capacitor;
and/or wherein said transient response corresponds to a response of a capacitive element to a voltage or current step;
and/or wherein said determining means are arranged to determine said integrity during said charging state before substantial voltage build-up in said capacitor;
and/or wherein said determining means comprise comparing means for comparing said at least one electrical parameter to at least one predetermined limit;
and/or wherein said at least one electrical parameter comprises at least one of a current through said electrical wiring and a voltage at said another end of said electrical wiring.

3. Assembly according to claim 1 or 2, wherein said discharging means comprise at least one of a voltage source, a current source and means for shorting said electrical wiring at said another end.

4. Assembly according to claim 3, wherein said another end of said electrical wiring provides a first and second terminal of which said first terminal is connected to said supply means at least in the charging state, wherein preferably:
said measuring means comprise a current meter connected to at least one of said first and second terminal, and
said integrity signal is indicative of failing electrical wiring if said measured current is below a predetermined limit.

5. Assembly according to claim 4, wherein said measuring means comprise:
a resistor connected in between said supply means and said first terminal; and
a voltage meter to measure a voltage drop over said resistor in said charging state;
wherein said integrity signal is indicative of failing electrical wiring if said voltage drop is below a predetermined limit.

6. Assembly according to claim 4 or 5, wherein said measuring means comprise:
a voltage meter to measure a wire voltage over said electrical wiring in said charging state;
wherein said integrity signal is indicative of failing electrical wiring if said wire voltage is above a predetermined limit;
and/or wherein said measuring means comprise:
a resistor connected to said second terminal; and
a voltage meter to measure a voltage over said resistor, wherein said integrity signal is indicative of failing electrical wiring if said voltage is below a predetermined limit.

7. Assembly according to any of the claims 4-6, wherein said discharging means comprise a voltage source and or a current source connectable to said second terminal, said switching means preferably comprising a controllable switch in between said voltage source and or current source and said second terminal.

8. Assembly according to any of the claims 4-7, wherein said discharging means comprise shorting means for shorting said electrical wiring between said first and second terminal, said switching means preferably comprising a controllable switch in between said supply means and said first terminal.

9. Assembly according to any of the claims 4-8, comprising a micro-controller having at least one input port for measuring said at least one electrical parameter at said another end, and at least one output port connected to said second terminal, wherein said micro-controller is programmed or arranged to periodically output a high voltage level for discharging said capacitor, wherein preferably:
said high voltage level corresponds to a supply voltage applied to said electrical wiring by said supply means;
and/or wherein said output port is a tri-state port;
and/or wherein said input port and said output port are combined into one I/O port connected to said second terminal and wherein said micro-controller is arranged to periodically switch the behaviour of said I/O port between that of said input port and that of said output port;
and/or wherein said I/O port is connected to said second terminal and to a resistor connected to ground.

10. Assembly according to claim 9, wherein said determining means are implemented in said micro-controller.

11. Assembly according to any of the previous claims, wherein said normally open device is a switch.

12. System for measuring an electrical state of a normally open device connected thereto by electrical wiring, comprising an assembly for determining the integrity of said electrical wiring as defined in any of the claims 1-11 in an assembled state, said state measuring device further comprising:
second measuring means for measuring at least one second electrical parameter;
second determining means for determining the state of said normally open device based on said measured at least one second electrical parameter.

13. System according to claim 12, wherein said second measuring means and said first measuring means are identical, and wherein said second determining means are arranged to determine said state at least during the charging state after substantial charge build-up in said capacitor, wherein preferably:
said measuring means are arranged to measure said at least one second electrical parameter at least twice during initial charging of said capacitor, and wherein said second determining means are arranged to determine the state of said normally open device using said at least two measurements of said at least one electrical parameter.

14. System according to claim 13, wherein said device is a peripheral belonging to a nurse call system and wherein said normally open device is a push button operable by a patient for calling medical assistance.

15. Method for determining the integrity of electrical wiring having connected a normally open device at one end thereof, comprising:
connecting a capacitor in parallel to said normally open device;
applying an electrical supply to another end of said electrical wiring;
disconnecting said electrical supply from said another end;
measuring at least one electrical parameter at said another end;
determining said integrity using said at least one electrical parameter and outputting a signal indicative of said integrity;
**characterized by** prior to said measuring:
discharging said capacitor from said another end; and
applying electrical supply to said another end for charging the capacitor;
further **characterized in that** said integrity is determined in dependence of a transient response corresponding to said at least one electrical parameter to said switch from said discharging to said charging.

## Patentansprüche

1. Einheit zum Feststellen der Integrität einer elektrischen Verkabelung (9), wobei die elektrische Verkabelung mit einem ihrer Enden an eine im Normalfall offene Vorrichtung (6) angeschlossen ist, wobei die Einheit Folgendes umfasst:
einen Kondensator (7), der in einem montierten Zustand parallel zu der im Normalfall offenen Vorrichtung angeschlossen ist; und
eine Vorrichtung zur Integritätsmessung (8), die in einem montierten Zustand an ein anderes Ende der elektrischen Verkabelung angeschlossen ist, wobei die Vorrichtung zur Integritätsmessung Folgendes umfasst:
ein Versorgungsmittel (10) zum Bereitstellen einer elektrischen Versorgung am anderen Ende der elektrischen Verkabelung;
ein Entlademittel (11) zum Entladen des Kondensators über das andere Ende der elektrischen Verkabelung;
ein Messmittel (12) zum Messen wenigstens eines elektrischen Parameters am anderen Ende;
ein Umschaltmittel (13), um wenigstens eines von dem Versorgungsmittel und dem Entlademittel an das andere Ende der elektrischen Verkabelung anzuschließen, wobei das Umschaltmittel dafür eingerichtet ist, die Vorrichtung zur Integritätsmessung zwischen einem Ladezustand, in dem das Versorgungsmittel den Kondensator lädt, und einem Entladezustand, in dem das Entlademittel den Kondensator entlädt, umzuschalten;
ein Feststellungsmittel (14) zum Feststellen der Integrität der elektrischen Verkabelung unter Verwendung des wenigstens einen elektrischen Parameters und zur Ausgabe eines Signals (15), das die Integrität anzeigt;
**dadurch gekennzeichnet, dass** das Feststellungsmittel so eingerichtet ist, dass es die Integrität in Abhängigkeit von einer dem wenigstens einen elektrischen Parameter entsprechenden Übergangsantwort auf eine Umschaltung vom Entladezustand in den Ladezustand feststellt.

2. Einheit nach Anspruch 1, wobei:
das Entlademittel dafür eingerichtet ist, den Kondensator im Wesentlichen vollständig zu entladen;
und/oder die Übergangsantwort einer Antwort eines kapazitiven Elements auf ein Spannungs- oder Stromstufensignal entspricht;
und/oder das Feststellungsmittel dafür eingerichtet ist, die Integrität während der Ladephase festzustellen, bevor in dem Kondensator eine wesentliche Spannung aufgebaut wurde;
und/oder das Feststellungsmittel ein Vergleichsmittel zum Vergleichen des wenigstens einen elektrischen Parameters mit wenigstens einem vorgegebenen Schwellwert umfasst;
und/oder der wenigstens eine elektrische Parameter einen Strom durch die elektrische Verkabelung und/oder eine Spannung am anderen Ende der elektrischen Verkabelung umfasst.

3. Einheit nach Anspruch 1 oder 2, wobei das Entlademittel wenigstens eines der folgenden Mittel umfasst: eine Spannungsquelle, eine Stromquelle und ein Mittel zum Kurzschließen der elektrischen Verkabelung am anderen Ende.

4. Einheit nach Anspruch 3, wobei das andere Ende der elektrischen Verkabelung einen ersten und einen zweiten Anschluss bereitstellt, von denen der erste Anschluss wenigstens im Ladezustand an das Versorgungsmittel angeschlossen ist, und wobei vorzugsweise:
das Messmittel einen Strommesser umfasst, der an den ersten und/oder zweiten Anschluss angeschlossen ist, und
das Integritätssignal eine fehlerhafte elektrische Verkabelung anzeigt, wenn der gemessene Strom unterhalb eines vorgegebenen Schwellwerts liegt.

5. Einheit nach Anspruch 4, wobei das Messmittel Folgendes umfasst:
einen Widerstand, der zwischen dem Versorgungsmittel und dem ersten Anschluss angeschlossen ist; und
einen Spannungsmesser zum Messen eines Spannungsabfalls über den Widerstand im Ladezustand;
wobei das Integritätssignal eine fehlerhafte elektrische Verkabelung anzeigt, wenn der Spannungsabfall unterhalb eines vorgegebenen Schwellwerts liegt.

6. Einheit nach Anspruch 4 oder 5, wobei das Messmittel Folgendes umfasst:
einen Spannungsmesser zum Messen einer Kabelspannung über die elektrische Verkabelung im Ladezustand;
wobei das Integritätssignal eine fehlerhafte elektrische Verkabelung anzeigt, wenn die Kabelspannung oberhalb eines vorgegebenen Schwellwerts liegt;
und/oder das Messmittel Folgendes umfasst:
einen Widerstand, der an den zweiten Anschluss angeschlossen ist; und
einen Spannungsmesser zum Messen einer Spannung über dem Widerstand, wobei das Integritätssignal eine fehlerhafte elektrische Verkabelung anzeigt, wenn die Spannung unterhalb eines vorgegebenen Schwellwerts liegt.

7. Einheit nach einem der Ansprüche 4 bis 6, wobei das Entlademittel eine Spannungsquelle und/oder eine Stromquelle umfasst, die an den zweiten Anschluss angeschlossen werden können, und wobei das Umschaltmittel vorzugsweise einen steuerbaren Schalter zwischen der Spannungsquelle und/oder der Stromquelle und dem zweiten Anschluss umfasst.

8. Einheit nach einem der Ansprüche 4 bis 7, wobei das Entlademittel ein Kurzschlussmittel zum Kurzschließen der elektrischen Verkabelung zwischen dem ersten und dem zweiten Anschluss umfasst und wobei das Umschaltmittel vorzugsweise einen steuerbaren Schalter zwischen dem Versorgungsmittel und dem ersten Anschluss umfasst.

9. Einheit nach einem der Ansprüche 4 bis 8, die einen Mikrokontroller umfasst, der wenigstens einen Eingangsport zum Messen des wenigstens einen elektrischen Parameters am anderen Ende und wenigstens einen Ausgangsport, der an den zweiten Anschluss angeschlossen ist, hat, wobei der Mikrokontrolle so programmiert oder dafür eingerichtet ist, dass er periodisch einen hohen Spannungspegel zum Entladen des Kondensators ausgibt, wobei gilt, dass vorzugsweise:
dieser hohe Spannungspegel einer Versorgungsspannung entspricht, die durch das Versorgungsmittel an die elektrische Verkabelung angelegt wird;
und/oder der Ausgangsport ein Tristate-Port ist;
und/oder der Eingangsport und der Ausgangsport in einem I/O-Port zusammengefasst sind, der mit dem zweiten Anschluss verbunden ist, und wobei der Mikrokontroller dafür eingerichtet ist, periodisch das Verhalten des I/O-Ports zwischen demjenigen des Eingangsports und demjenigen des Ausgangsports umzuschalten;
und/oder der I/O-Port mit dem zweiten Anschluss und mit einem an Masse angeschlossenen Widerstand verbunden ist.

10. Einheit nach Anspruch 9, wobei das Feststellungsmittel im Mikrokontroller implementiert ist.

11. Einheit nach einem der vorhergehenden Ansprüche, wobei die im Normalfall offene Vorrichtung ein Schalter ist.

12. System zum Messen eines elektrischen Zustands einer im Normalfall offenen Vorrichtung, das mit dieser über eine elektrische Verkabelung verbunden ist und das eine Einheit zum Feststellen der Integrität der elektrischen Verkabelung nach einem der Ansprüche 1 bis 11 in einem montierten Zustand umfasst, wobei die Zustandsmessvorrichtung außerdem Folgendes umfasst:
ein zweites Messmittel zum Messen wenigstens eines zweiten elektrischen Parameters;
ein zweites Feststellungsmittel zum Feststellen des Zustands der im Normalfall offenen Vorrichtung basierend auf dem gemessenen wenigstens einen zweiten elektrischen Parameter.

13. System nach Anspruch 12, wobei das zweite Messmittel und das erste Messmittel identisch sind und wobei das zweite Feststellungsmittel dafür eingerichtet ist, den Zustand wenigstens während der Ladephase festzustellen, nachdem im Kondensator eine erhebliche Ladung aufgebaut wurde, wobei vorzugsweise gilt, dass:
das Messmittel dafür eingerichtet ist, den wenigstens einen zweiten elektrischen Parameter während des beginnenden Ladevorgangs des Kondensators wenigstens zweimal zu messen, und wobei das zweite Feststellungsmittel dafür eingerichtet ist, den Zustand der im Normalfall offenen Vorrichtung unter Verwendung der wenigstens zwei Messungen des wenigstens einen elektrischen Parameters festzustellen.

14. System nach Anspruch 13, wobei die Vorrichtung ein Peripheriegerät ist, das zu einem Rufsystem für Krankenschwestern gehört, und wobei die im Normalfall offene Vorrichtung eine Drucktaste ist, die vom Patienten bedient werden kann, um medizinische Hilfe zu rufen.

15. Verfahren zum Feststellen der Integrität einer elektrischen Verkabelung an deren einem Ende eine im Normalfall offene Vorrichtung angeschlossen ist, Folgendes umfassend:
Anschließen eines Kondensators parallel zu der im Normalfall offenen Vorrichtung;
Anschließen einer elektrischen Versorgung an ein anderes Ende der elektrischen Verkabelung;
Trennen der elektrischen Versorgung von dem anderen Ende;
Messen von wenigstens einem elektrischen Parameter an dem anderen Ende;
Feststellen der Integrität unter Verwendung des wenigstens einen elektrischen Parameters und Ausgeben eines Signals, das die Integrität anzeigt;
**dadurch gekennzeichnet, dass** vor der Messung Folgendes ausgeführt wird:
Entladen des Kondensators über das andere Ende; und
Anlegen einer elektrischen Versorgung an das andere Ende zum Laden des Kondensators;
und außerdem **dadurch gekennzeichnet, dass** die Integrität in Abhängigkeit von einer dem wenigstens einen elektrischen Parameter entsprechenden Übergangsantwort auf das Umschalten vom Entladen zum Laden festgestellt wird.

## Revendications

1. Ensemble pour déterminer l'intégrité d'un câblage électrique (9), ledit câblage électrique étant connecté à un dispositif normalement ouvert (6) à une extrémité de celui-ci, dans lequel l'ensemble comprend :
un condensateur (7) qui, dans un état assemblé, est connecté en parallèle au dit dispositif normalement ouvert ; et
un dispositif de mesure d'intégrité (8) qui, dans un état assemblé, est connecté à une autre extrémité dudit câblage électrique, ledit dispositif de mesure d'intégrité comprenant :
des moyens d'alimentation (10) pour appliquer une alimentation électrique à ladite autre extrémité dudit câblage électrique ;
des moyens de décharge (11) pour décharger ledit condensateur à partir de ladite autre extrémité dudit câblage électrique ;
des moyens de mesure (12) pour mesurer au moins un paramètre électrique à ladite autre extrémité ;
des moyens de commutation (13) pour commuter au moins l'un desdits moyens d'alimentation et desdits moyens de décharge vers ladite autre extrémité dudit câblage électrique, dans lequel lesdits moyens de commutation sont agencés pour commuter ledit dispositif de mesure d'intégrité entre un état de charge, dans lequel lesdits moyens d'alimentation chargent ledit condensateur, et un état de décharge, dans lequel lesdits moyens de décharge déchargent ledit condensateur ;
des moyens de détermination (14) pour déterminer l'intégrité dudit câblage électrique en utilisant ledit au moins un paramètre électrique et pour délivrer un signal (15) indicatif de ladite intégrité ;
**caractérisé en ce que** lesdits moyens de détermination sont agencés pour déterminer ladite intégrité en fonction d'une réponse transitoire correspondant au dit au moins un paramètre électrique à une commutation dudit état de décharge vers ledit état de charge.

2. Ensemble selon la revendication 1, dans lequel :
lesdits moyens de décharge sont agencés pour décharger sensiblement entièrement ledit condensateur ;
et/ou dans lequel ladite réponse transitoire correspond à une réponse d'un élément capacitif à un échelon de tension ou de courant ;
et/ou dans lequel lesdits moyens de détermination sont agencés pour déterminer ladite intégrité pendant ledit état de charge avant le développement d'une tension substantielle dans ledit condensateur ;
et/ou dans lequel lesdits moyens de détermination comprennent des moyens de comparaison pour comparer ledit au moins un paramètre électrique à au moins une limite prédéterminée ;
et/ou dans lequel ledit au moins un paramètre électrique comprend au moins l'un d'un courant à travers ledit câblage électrique et d'une tension à ladite autre extrémité dudit câblage électrique.

3. Ensemble selon la revendication 1 ou 2, dans lequel lesdits moyens de décharge comprennent au moins l'un d'une source de tension, d'une source de courant et de moyens pour mettre en court-circuit ledit câblage électrique à ladite autre extrémité.

4. Ensemble selon la revendication 3, dans lequel ladite autre extrémité dudit câblage électrique fournit des première et deuxième bornes dont ladite première borne est connectée auxdits moyens d'alimentation au moins dans l'état de charge, dans lequel, de préférence :
lesdits moyens de mesure comprennent un ampèremètre connecté à au moins l'une desdites première et deuxième bornes, et
ledit signal d'intégrité est indicatif d'un câblage électrique défaillant si ledit courant mesuré est au-dessous d'une limite prédéterminée.

5. Ensemble selon la revendication 4, dans lequel lesdits moyens de mesure comprennent :
une résistance connectée entre lesdits moyens d'alimentation et ladite première borne ; et
un voltmètre pour mesurer une chute de tension sur ladite résistance dans ledit état de charge ;
dans lequel ledit signal d'intégrité est indicatif d'un câblage électrique défaillant si ladite chute de tension est au-dessous d'une limite prédéterminée.

6. Ensemble selon la revendication 4 ou 5, dans lequel lesdits moyens de mesure comprennent :
un voltmètre pour mesurer une tension de câble sur ledit câblage électrique dans ledit état de charge ;
dans lequel ledit signal d'intégrité est indicatif d'un câblage électrique défaillant si ladite tension de câble est au-dessus d'une limite prédéterminée ;
et/ou dans lequel lesdits moyens de mesure comprennent :
une résistance connectée à ladite deuxième borne ; et
un voltmètre pour mesurer une tension sur ladite résistance, dans lequel ledit signal d'intégrité est indicatif d'un câblage électrique défaillant si ladite tension est au-dessous d'une limite prédéterminée.

7. Ensemble selon l'une quelconque des revendications 4 à 6, dans lequel lesdits moyens de décharge comprennent une source de tension et/ou une source de courant pouvant être connectées à ladite deuxième borne, lesdits moyens de commutation comprenant de préférence un commutateur pouvant être commandé entre ladite source de tension et/ou ladite source de courant et ladite deuxième borne.

8. Ensemble selon l'une quelconque des revendications 4 à 7, dans lequel lesdits moyens de décharge comprennent des moyens de mise en court-circuit pour mettre en court-circuit ledit câblage électrique entre lesdites première et deuxième bornes, lesdits moyens de commutation comprenant de préférence un commutateur pouvant être commandé entre lesdits moyens d'alimentation et ladite première borne.

9. Ensemble selon l'une quelconque des revendications 4 à 8, comprenant un micro-contrôleur ayant au moins un port d'entrée pour mesurer ledit au moins un paramètre électrique à ladite autre extrémité, et au moins un port de sortie connecté à ladite deuxième borne, dans lequel ledit micro-contrôleur est programmé ou agencé pour délivrer périodiquement un niveau de tension élevé pour décharger ledit condensateur, dans lequel, de préférence :
ledit niveau de tension élevé correspond à une tension d'alimentation appliquée au dit câblage électrique par lesdits moyens d'alimentation ;
et/ou dans lequel ledit port de sortie est un port à trois états ;
et/ou dans lequel ledit port d'entrée et ledit port de sortie sont combinés en un port d'entrée/sortie connecté à ladite deuxième borne, et dans lequel ledit micro-contrôleur est agencé pour commuter périodiquement le comportement dudit port d'entrée/sortie entre celui dudit port d'entrée et celui dudit port de sortie ;
et/ou dans lequel ledit port d'entrée/sortie est connecté à ladite deuxième borne et à une résistance connectée à la masse.

10. Ensemble selon la revendication 9, dans lequel lesdits moyens de détermination sont mis en oeuvre dans ledit micro-contrôleur.

11. Ensemble selon l'une quelconque des revendications précédentes, dans lequel ledit dispositif normalement ouvert est un commutateur.

12. Système pour mesurer un état électrique d'un dispositif normalement ouvert connecté à celui-ci par un câblage électrique, comprenant un ensemble pour déterminer l'intégrité dudit câblage électrique tel que défini dans l'une quelconque des revendications 1 à 11 dans un état assemblé, ledit dispositif de mesure d'état comprenant en outre :
des deuxièmes moyens de mesure pour mesurer au moins un deuxième paramètre électrique ;
des deuxièmes moyens de détermination pour déterminer l'état dudit dispositif normalement ouvert sur la base dudit au moins un deuxième paramètre électrique mesuré.

13. Système selon la revendication 12, dans lequel lesdits deuxièmes moyens de mesure et lesdits premiers moyens de mesure sont identiques, et dans lequel lesdits deuxièmes moyens de détermination sont agencés pour déterminer ledit état au moins pendant l'état de charge après une accumulation de charges substantielles dans ledit condensateur, dans lequel, de préférence :
lesdits moyens de mesure sont agencés pour mesurer ledit au moins un deuxième paramètre électrique au moins deux fois pendant la charge initiale dudit condensateur, et dans lequel lesdits deuxièmes moyens de détermination sont agencés pour déterminer l'état dudit dispositif normalement ouvert en utilisant lesdites au moins deux mesures dudit au moins un paramètre électrique.

14. Système selon la revendication 13, dans lequel ledit dispositif est un périphérique appartenant à un système d'appel d'infirmier, et dans lequel ledit dispositif normalement ouvert est bouton-poussoir pouvant être actionné par un patient pour un appel d'assistance médicale.

15. Procédé pour déterminer l'intégrité d'un câblage électrique ayant un dispositif normalement ouvert connecté à une extrémité de celui-ci, consistant à :
connecter un condensateur en parallèle au dit dispositif normalement ouvert ;
appliquer une alimentation électrique à une autre extrémité dudit câblage électrique ;
déconnecter ladite alimentation électrique de ladite autre extrémité ;
mesurer au moins un paramètre électrique à ladite autre extrémité ;
déterminer ladite intégrité en utilisant ledit au moins un paramètre électrique et délivrer un signal indicatif de ladite intégrité ;
**caractérisé**, avant ladite mesure, par les étapes consistant à :
décharger ledit condensateur à partir de ladite autre extrémité ; et
appliquer une alimentation électrique à ladite autre extrémité pour charger le condensateur ;
**caractérisé en outre en ce que** ladite intégrité est déterminée en fonction d'une réponse transitoire correspondant au dit au moins un paramètre électrique à ladite commutation de ladite décharge vers ladite charge.
